# EUROPEAN PATENT APPLICATION

(11) **EP 4 444 057 A1**
(43) Date of publication of application: **09.10.2024**
(21) Application number: 24164466.5
(22) Date of filing: 19.03.2024
(51) Int. Cl.: H10B 43/10, H10B 43/27, H10B 43/50

(54) **MEMORY DEVICE**

(30) Priority: 24.03.2023 KR 20230039036; 22.05.2023 KR 20230065881
(71) Applicant: Samsung Electronics Co., Ltd., Suwon-si, Gyeonggi-do 16677 (KR)
(72) Inventor: KANAMORI, Kohji, Suwon-si, Gyeonggi-do 16677 (KR); KANG, Seogoo, Suwon-si, Gyeonggi-do 16677 (KR); KIM, Kyungdong, Suwon-si, Gyeonggi-do 16677 (KR); LEE, Seunghyun, Suwon-si, Gyeonggi-do 16677 (KR); HAN, Jeehoon, Suwon-si, Gyeonggi-do 16677 (KR)
(74) Representative: Kuhnen & Wacker Patent- und Rechtsanwaltsbüro PartG mbB

(57) **Abstract**

A memory device is provided. The memory device includes a first cell array stack including first gate electrodes, a first channel structure, and first pad portions respectively connected to the first gate electrodes and having a step shape, a second cell array stack disposed on the first cell array stack and including second gate electrodes, a second channel structure, and second pad portions respectively connected to the second gate electrodes and having a step shape, wherein the second pad portions overlap the first pad portions in the first direction, and a vertical contact passing through any one of the first pad portions, first extension portions below the any one of the first pad portions, any one of the second pad portions, and second extension portions below the any one of the second pad portions, to extend in the first direction.

## Description

### BACKGROUND

For electronic systems requiring data storage, a memory device capable of storing high-capacity data is required. As a method of increasing the data storage capacity of memory devices, a memory device including three-dimensionally arranged memory cells, instead of two-dimensionally arranged memory cells, has been proposed. In addition, a memory device has been proposed in which a portion of the memory device is formed on a first substrate, another portion of the memory device is formed on a second substrate, and the first substrate is bonded to the second substrate.

### SUMMARY

The present disclosure provides a memory device with improved operating characteristics and improved degree of integration.

According to an aspect of the present disclosure, there is provided a memory device including a first cell array stack including a plurality of first gate electrodes arranged to be apart from each other in a first direction, a first channel structure passing through the plurality of first gate electrodes, and a plurality of first pad portions respectively connected to the plurality of first gate electrodes and having a step shape, a second cell array stack disposed on the first cell array stack and including a plurality of second gate electrodes arranged to be apart from each other in the first direction, a second channel structure passing through the plurality of second gate electrodes, and a plurality of second pad portions respectively connected to the plurality of second gate electrodes and having a step shape, wherein the plurality of second pad portions overlap the plurality of first pad portions in the first direction, and a vertical contact passing through any one of the plurality of first pad portions, first extension portions of the plurality of first gate electrodes arranged below the any one of the plurality of first pad portions, any one of the plurality of second pad portions, and second extension portions of the plurality of second gate electrodes arranged below the any one of the plurality of second pad portions, to extend in the first direction.

According to another aspect of the present disclosure, there is provided a memory device including a first cell array stack including a first common source plate, a plurality of first gate electrodes arranged to be apart from each other in a first direction on the first common source plate, a first channel structure passing through the plurality of first gate electrodes, a plurality of first pad portions respectively connected to the plurality of first gate electrodes and having a step shape, and a first bit line connected to the first channel structure, a second cell array stack disposed on the first cell array stack and including a second common source plate, a plurality of second gate electrodes arranged to be apart from each other in the first direction on the second common source plate, a second channel structure passing through the plurality of second gate electrodes, a plurality of second pad portions respectively connected to the plurality of second gate electrodes and having a step shape, and a second bit line connected to the second channel structure, and a vertical contact extending in the first direction through any one of the plurality of first pad portions and any one of the plurality of second pad portions, electrically connected to the any one of the plurality of first pad portions, and electrically connected to the any one of the plurality of second pad portions.

According to another aspect of the present disclosure, there is provided a memory device including a first cell array stack including a first common source plate, a plurality of first gate electrodes arranged to be apart from each other in a first direction on the first common source plate, a first channel structure passing through the plurality of first gate electrodes, a plurality of first pad portions respectively connected to the plurality of first gate electrodes and having a step shape, and a first bit line connected to the first channel structure, a second cell array stack disposed on the first cell array stack and including a second common source plate, a plurality of second gate electrodes arranged to be apart from each other in the first direction on the second common source plate, a second channel structure passing through the plurality of second gate electrodes, a plurality of second pad portions respectively connected to the plurality of second gate electrodes and having a step shape, and a second bit line connected to the second channel structure, a vertical contact extending in the first direction through any one of the plurality of first pad portions and any one of the plurality of second pad portions, electrically connected to the any one of the plurality of first pad portions, and electrically connected to the any one of the plurality of second pad portions, and a peripheral circuit stack disposed on the second cell array stack and including a word line driving circuit electrically connected to the vertical contact, wherein the plurality of second pad portions overlap the plurality of first pad portions in the first direction, and the any one of the plurality of first pad portions and the any one of the plurality of second pad portions are electrically connected to the word line driving circuit.

### BRIEF DESCRIPTION OF THE DRAWINGS

Implementations will be more clearly understood from the following detailed description taken in conjunction with the accompanying drawings in which:
FIG. 1 is a block diagram of a memory device according to some implementations;
FIG. 2 is a circuit diagram illustrating a memory block according to some implementations;
FIG. 3 is a perspective view illustrating a representative configuration of a memory device according to some implementations;
FIG. 4 is a plan layout view of portion A of FIG. 3;
FIG. 5 is a cross-sectional view taken along line B 1-B 1' of FIG. 4;
FIG. 6 is a cross-sectional view taken along line B2-B2' of FIG. 4;
FIG. 7 is a perspective view schematically illustrating a portion of an extension region of FIG. 3;
FIGS. 8 and 9 illustrate structures of a first pad portion that may be employed in a memory device according to some implementations;
FIGS. 10 to 13 illustrate structures of a first channel structure that may be employed in a memory device according to some implementations;
FIG. 14 is a cross-sectional view illustrating a memory device according to some implementations;
FIG. 15 is a cross-sectional view illustrating a memory device according to some implementations;
FIG. 16 is a diagram schematically illustrating a data storage system including a memory device according to some implementations;
FIG. 17 is a perspective view schematically illustrating a data storage system including a memory device according to some implementations; and
FIG. 18 is a schematic cross-sectional view of semiconductor packages according to some implementations.

### DETAILED DESCRIPTION

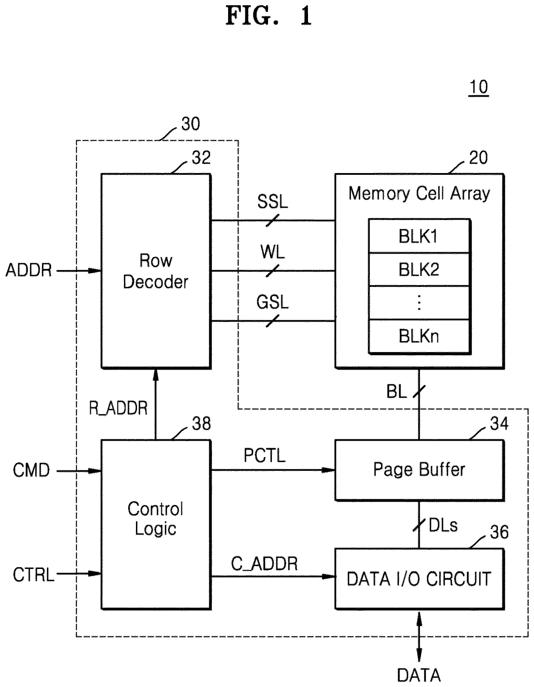

FIG. 1 is a block diagram of a memory device 10 according to some implementations.

Referring to FIG. 1, the memory device 10 includes a memory cell array 20 and a peripheral circuit 30. The memory cell array 20 includes a plurality of memory cell blocks BLK1, BLK2, ..., BLKn. Each of the plurality of memory cell blocks BLK1, BLK2, ..., BLKn may include a plurality of memory cells. The memory cell blocks BLK1, BLK2, ..., BLKn may be connected to the peripheral circuit 30 through a bit line BL, a word line WL, a string select line SSL, and a ground select line GSL.

The peripheral circuit 30 includes a row decoder 32, a page buffer 34, a data input/output (I/O) circuit 36, and a control logic 38. Although not shown in FIG. 1, the peripheral circuit 30 may further include an I/O interface, a column logic, a voltage generating unit, a pre-decoder, a temperature sensor, a command decoder, an address decoder, an amplifier circuit, and the like.

The memory cell array 20 may be connected to a page buffer 34 through the bit line BL and may be connected to a row decoder 32 through the word line WL, the string select line SSL, and the ground select line GSL. In the memory cell array 20, each of the memory cells included in the memory cell blocks BLK1, BLK2, ..., BLKn may be a flash memory cell. The memory cell array 20 may include a 3D memory cell array. The 3D memory cell array may include a plurality of NAND strings, and each of the NAND strings may include a plurality of memory cells connected to a plurality of word lines WL vertically stacked on a substrate.

The peripheral circuit 30 may receive an address ADDR, a command CMD, and a control signal CTRL from the outside of the memory device 10 and may transmit and receive data DATA to and from a device outside the memory device 10.

In response to the address ADDR from the outside, the row decoder 32 may select at least one of the memory cell blocks BLK1, BLK2, ..., BLKn and may select a word line WL, a string select line SSL, and a ground select line GSL of the selected memory cell block. The row decoder 32 may transmit a voltage for performing a memory operation to the word line WL of the selected memory cell block.

The page buffer 34 may be connected to the memory cell array 20 through a bit line BL. During a program operation, the page buffer 34 may operate as a write driver to apply a voltage according to the data DATA to be stored in the memory cell array 20 to the bit line BL, and during a read operation, the page buffer 34 may operate as a sense amplifier to sense the data DATA stored in the memory cell array 20. The page buffer 34 may operate according to a control signal PCTL provided from the control logic 38.

The data I/O circuit 36 may be connected to the page buffer 34 through data lines DLs. During a program operation, the data I/O circuit 36 may receive the data DATA from a memory controller (not shown) and provide program data DATA to the page buffer 34 based on the column address C_ADDR provided from the control logic 38. During a read operation, the data I/O circuit 36 transfers the read data DATA stored in the page buffer 34 to the memory controller based on the column address C_ADDR provided from the control logic 38.

The data I/O circuit 36 may transfer an input address or command to the control logic 38 or the row decoder 32. The peripheral circuit 30 may further include an electrostatic discharge (ESD) circuit and a pull-up/pull-down driver.

The control logic 38 may receive the command CMD and the control signal CTRL from the memory controller. The control logic 38 may provide the row address R_ADDR to the row decoder 32 and the column address C_ADDR to the data I/O circuit 36. The control logic 38 may generate various internal control signals used in the memory device 10 in response to the control signal CTRL. For example, the control logic 38 may adjust a voltage level provided to the word line WL and the bit line BL when a memory operation, such as a program operation or an erase operation, is performed.

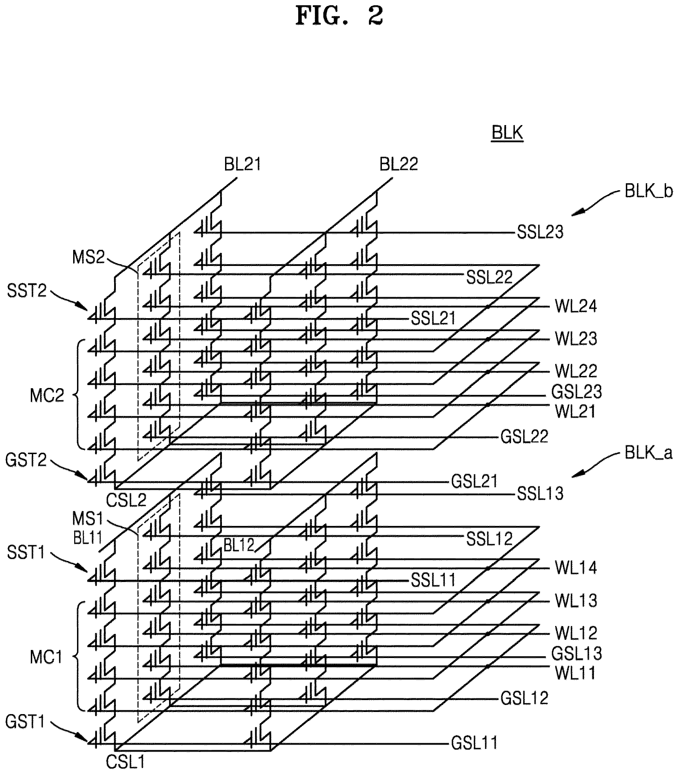

FIG. 2 is a circuit diagram illustrating a memory block BLK according to some implementations.

Referring to FIG. 2, the memory block BLK may correspond to one of the plurality of memory blocks BLK1 to BLKn of FIG. 1. The memory block BLK includes a first sub-block BLK_a and a second sub-block BLK_b arranged at different vertical levels and vertically overlapping each other. The first sub-block BLK_a may include first NAND strings MS1, and the second sub-block BLK_b may include second NAND strings MS2.

The first NAND string MS1 may include a first string select transistor SST1, a plurality of first memory cells MC1, and a first ground select transistor GST1 connected in series. The second NAND string MS2 may include a second string select transistor SST2, a plurality of second memory cells MC2, and a second ground select transistor GST2 connected in series. The first string select transistor SST1 and the first ground select transistor GST1 and the first memory cells MC1 included in the first NAND string MS1 may form a stacked structure in a vertical direction on the substrate. The second string select transistor SST2 and the second ground select transistor GST2 and the second memory cells MC2 included in the second NAND string MS2 may form a stacked structure on the substrate in the vertical direction.

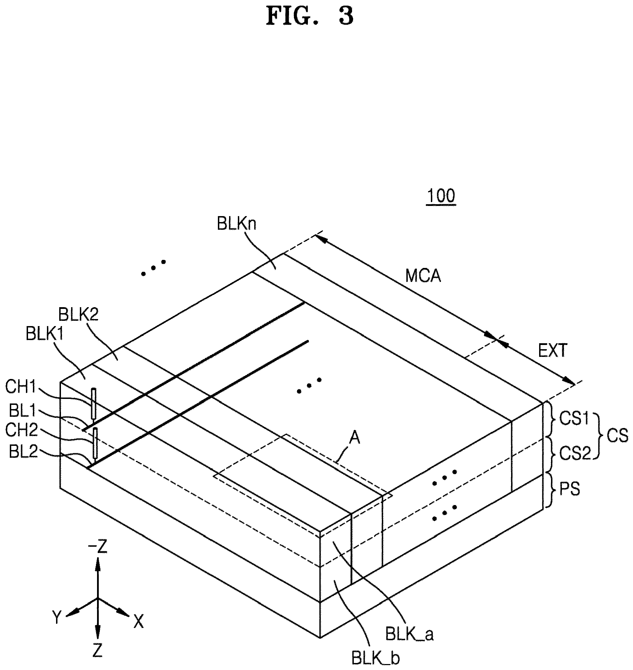

At an upper end of the first NAND string MS1, first bit lines BL11 and BL12 may extend in a first direction (e.g., the Y direction of FIG. 3) and first word lines WL11, WL12, WL13 and WL14 may extend in a second direction (e.g., the X direction of FIG. 3). The first NAND strings MS1 may be located between the first bit line BL1 and the first common source line CSL1. The first string select transistor SST1 may be connected to corresponding first string select lines SSL11, SSL12, and SSL13. The first memory cells MC1 may be connected to corresponding first word lines WL11, WL12, WL13, and WL14, respectively. The first ground select transistor GST1 may be connected to corresponding first ground select lines GSL11, GSL12, and GSL13. The first string select transistor SST1 may be connected to a corresponding bit line, and the first ground select transistor GST1 may be connected to the first common source line CSL1.

At an upper end of the second NAND string MS2, the second bit lines BL21 and BL22 may extend in the first direction (e.g., the Y direction of FIG. 3) and the second word lines WL21, WL22, WL23, and WL24 may extend in the second direction (e.g., the X direction of FIG. 3). Second NAND strings MS2 may be located between the second bit line BL2 and the second common source line CSL2. The second string select transistor SST2 may be connected to corresponding second string select lines SSL21, SSL22, and SSL23. The second memory cells MC2 may be connected to corresponding second word lines WL21, WL22, WL23, and WL24, respectively. The second ground select transistor GST2 may be connected to corresponding second ground select lines GSL21, GSL22, and GSL23. The second string select transistor SST2 may be connected to a corresponding bit line, and the second ground select transistor GST2 may be connected to the second common source line CSL2.

Here, the number of NAND strings, the number of word lines, the number of bit lines, the number of ground select lines, and the number of string select lines may be variously changed according to some implementations.

In some implementations, the same voltage may be applied to each of the first word lines WL11, WL12, WL13, and WL14 and each of the corresponding second word lines WL21, WL22, WL23, and WL24. For example, the lowermost first word line WL11 and the lowermost second word line WL21 may be electrically connected to one word line driving circuit (e.g., a pass transistor), and the same voltage may be applied to the lowermost first word line WL11 and the lowermost second word line WL21. Similarly, the uppermost first word line WL14 and the uppermost second word line WL24 may be electrically connected to one word line driving circuit (e.g., the pass transistor), and the same voltage may be applied to the uppermost first word line WL14 and the uppermost second word line WL24.

In some implementations, the same voltage may be applied to each of the first string select lines SSL11, SSL12, and SSL13 and each of the corresponding second string select lines SSL21, SSL22, and SSL23. For example, the first string select line SSL11 located on the left and the second string select line SSL21 located on the left may be electrically connected to one string select line driving circuit, and the same voltage may be applied to the first string select line SSL11 located on the left and the second string select line SSL21 located on the left.

In some implementations, each of the first bit lines BL11 and BL12 is configured to apply a voltage from the first page buffer circuit to the corresponding first NAND string MS1, and each of the second bit lines BL21 and BL22 may be configured to apply a voltage from the second page buffer circuit to the second NAND string MS2.

In some implementations, the same word line voltage as that of the second memory cell MC2 connected to the lowermost second word line WL21 in the second NAND string MS2 may be applied to the first memory cell MC1 connected to the lowermost first word line WL11 in the first NAND string MS1, and a bit line voltage applied to the first memory cell MC1 through the first bit line BL11 may be independent of a bit line voltage applied to the second memory cell MC2 through the second bit line BL21. Accordingly, the first memory cell MC1 may be independently programmed from the second memory cell MC2.

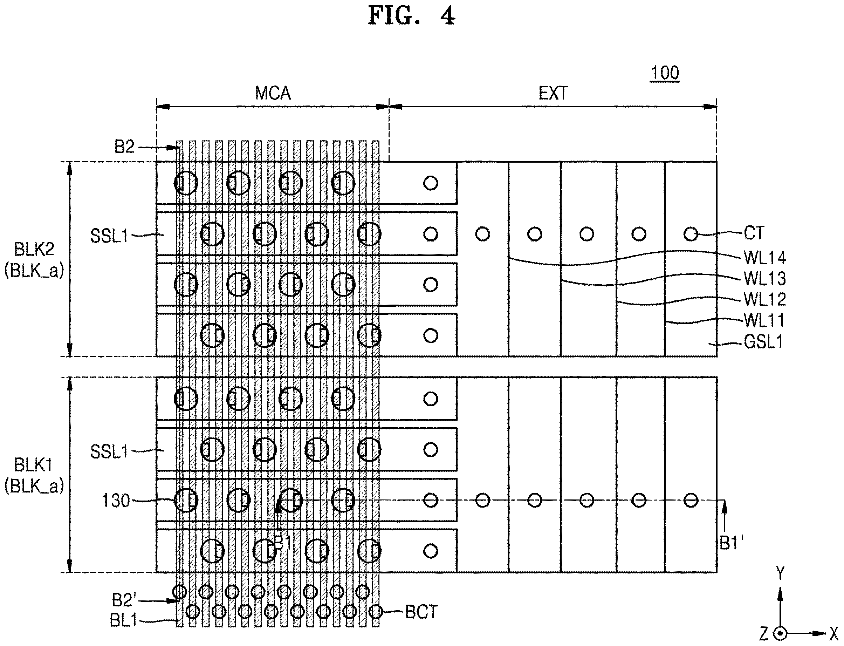

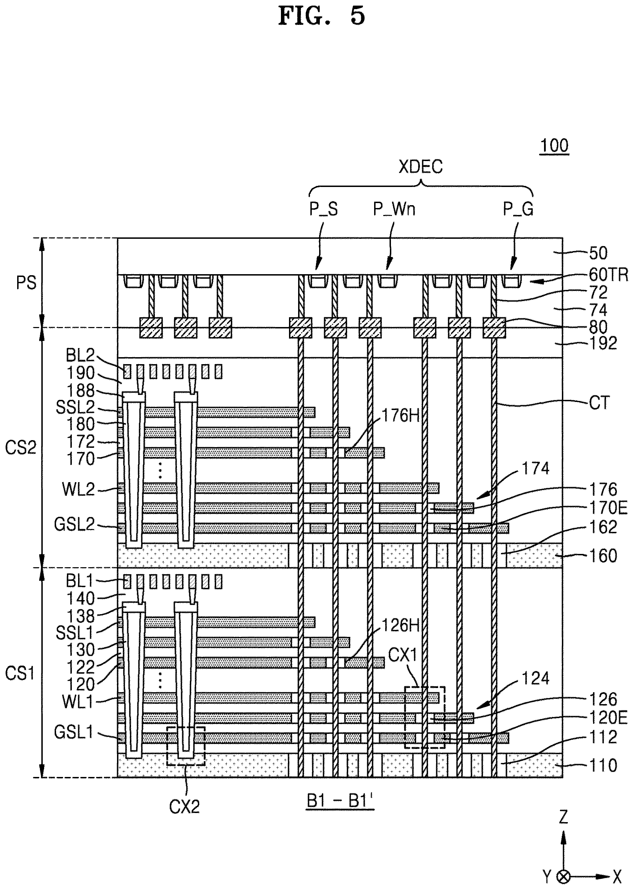

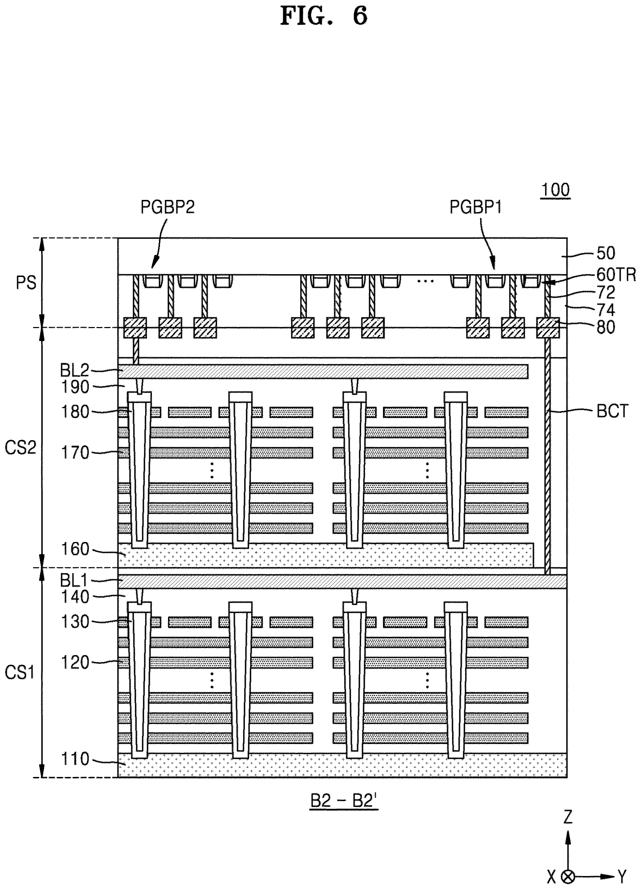

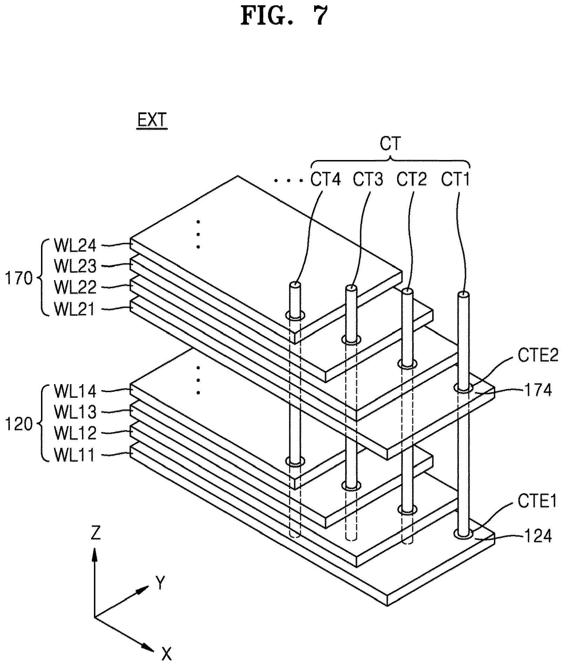

FIG. 3 is a perspective view illustrating a representative configuration of a memory device 100 according to some implementations. FIG. 4 is a plan layout view of portion A of FIG. 3. FIG. 5 is a cross-sectional view taken along line B 1-B 1' of FIG. 4. FIG. 6 is a cross-sectional view taken along line B2-B2' of FIG. 4. FIG. 7 is a perspective view schematically illustrating a portion of an extension region EXT of FIG. 3.

Referring to FIGS. 3 to 7, the memory device 100 includes a cell array stack CS and a peripheral circuit stack PS that overlap each other in the vertical direction (a Z direction). The cell array stack CS may include the memory cell array 20 described above with reference to FIG. 1, and the peripheral circuit stack PS may include the peripheral circuit 30 described above with reference to FIG. 1.

The cell array stack CS includes a plurality of memory cell blocks BLK1, BLK2, ..., BLKn. Each of the memory cell blocks BLK1, BLK2, ..., BLKn may include three-dimensionally arranged memory cells. Each of the memory cell blocks BLK1, BLK2, ..., BLKn may include a second sub-block BLK_b and a first sub-block BLK_a overlapping in the vertical direction Z on the peripheral circuit stack PS. The first sub-block BLK_a includes a first channel structure CH1 and a first bit line BL1 connected to the first channel structure CH1, and the second sub-block BLK_b may include a second channel structure CH2 located in a position overlapping the first channel structure CH1 and a second bit line BL2 connected to the second channel structure CH2.

The cell array stack CS includes a memory cell region MCA and an extension region EXT. The memory cell region MCA may be a region in which the memory cell array 20 described above with reference to FIG. 1 is located, and the extension region EXT may be a region in which an electrical connection component, for example, a pad portion and/or a contact, for the word line WL of each memory cell array 20 is located.

In some implementations, the cell array stack CS includes a first cell array stack CS1 and a second cell array stack CS2 arranged to overlap each other on the peripheral circuit stack PS. The first sub-block BLK_a may be located in the first cell array stack CS1, and the second sub-block BLK_b may be located in the second cell array stack CS2.

In FIG. 3, it is illustrated that the second cell array stack CS2 is disposed directly on the peripheral circuit stack PS so that the second bit line BL2 included in the second cell array stack CS2 is located to be closer to the peripheral circuit stack PS than the second channel structure CH2 is, and the first cell array stack CS1 is disposed on the second cell array stack CS2 so that the first bit line BL 1 included in the first cell array stack CS1 is closer to the second cell array stack CS2 than the first channel structure CH1 is, as an example. Here, a direction toward the peripheral circuit stack PS is referred to as a Z direction and a direction toward the first cell array stack CS1 is referred to as a -Z direction.

The peripheral circuit stack PS includes a peripheral circuit transistor 60TR and a peripheral circuit interconnection structure 72 disposed on the substrate 50. An active region may be defined on the active surface of the substrate 50, and a plurality of peripheral circuit transistors 60TR may be formed on the active region of the substrate 50. The peripheral circuit interconnection structure 72 and an interlayer insulating layer 74 covering the peripheral circuit interconnection structure 72 may be disposed on the active surface of the substrate 50. In addition, at least a portion of the peripheral circuit interconnection structure 72 may be connected to a bonding pad 80 disposed at an interface between the peripheral circuit stack PS and the second cell array stack CS2. In some implementations, the peripheral circuit stack PS may be attached to the second cell array stack CS2 through the bonding pad 80 using a metal-oxide bonding method.

However, in other implementations, the first cell array stack CS1 and the second cell array stack CS2 may be sequentially formed on the peripheral circuit stack PS in a direct stack manner, and in this case, the bonding pads 80 may be omitted. In these implementations, the first bit line BL1 included in the first cell array stack CS1 may be located farther from the peripheral circuit stack PS than the first channel structure CH1.

The first cell array stack CS1 may include a first common source plate 110, a plurality of first gate electrodes 120, a first channel structure 130, a plurality of first pad portions 124, and a plurality of first bit lines BL1.

As shown in FIG. 5, the first gate electrodes 120 may be apart from each other in the vertical direction Z on the first common source plate 110. For example, the first gate electrodes 120 may be alternately arranged with the first insulating layers 122 on a first surface of the first common source plate 110, and a width thereof in the first horizontal direction X may decrease in a direction away from the first surface of the first common source plate 110.

For example, the lowermost first gate electrode 120 (or the first gate electrode 120 located to be closest to the first common source plate 110), among the first gate electrodes 120, may be the first ground select line GSL1, and the uppermost first gate electrode 120 (or the first gate electrode 120 located to be farthest from the first common source plate 110), among the first gate electrodes 120, may be the first string select line SSL1. Among the first gate electrodes 120, the other first gate electrodes 120 may be the first word line WL1.

The first channel structure 130 may pass through the first gate electrodes 120 and extend in the vertical direction Z. The first channel structures 130 may be arranged to be apart from each other at predetermined intervals in the first horizontal direction X, the second horizontal direction Y, and a third horizontal direction (e.g., diagonal direction) or may be arranged in a zigzag shape or a staggered shape.

The first pad portions 124 may be connected to the first gate electrodes 120 and may have a step shape. A first cover insulating layer 140 may be located to cover the first pad portions 124. The first bit lines BL1 may be connected to a first end portion of the first channel structure 130 (e.g., the first end portion opposite to a second end portion of the first channel structure 130 connected to the first common source plate 110) and may extend in the second horizontal direction Y.

The second cell array stack CS2 may include a second common source plate 160, a plurality of second gate electrodes 170, a second channel structure 180, a plurality of second pad portions 174, and a plurality of second bit lines BL2.

As shown in FIG. 5, the second common source plate 160 may be disposed on the first bit lines BL1. The second gate electrodes 170 may be apart from each other in the vertical direction Z on the second common source plate 160. For example, a plurality of second gate electrodes 170 may be disposed on the second common source plate 160 so that the second common source plate 160 and the first bit line BL1 are arranged between the second gate electrodes 170 and the first gate electrodes 120, and the second gate electrodes 170 may be alternately arranged with the second insulating layers 172.

For example, the lowermost second gate electrode 170 (or the second gate electrode 170 disposed closest to the second common source plate 160), among the second gate electrodes 170, may be the second ground select line GSL2, and the uppermost second gate electrode 170 (or the second gate electrode 170 disposed farthest from the second common source plate 160), among the second gate electrodes 170, may be the second string select line SSL2. Among the second gate electrodes 170, the other second gate electrode 170 may be the second word line WL2. The second channel structure 180 may pass through the second gate electrodes 170 and extend in the vertical direction Z.

The second pad portions 174 may be connected to the second gate electrodes 170 and may have a step shape. The second pad portions 174 may be disposed in positions vertically overlapping the first pad portions 124. For example, the uppermost second pad portion 174 connected to the uppermost second gate electrode 170 may vertically overlap the uppermost first pad portion 124 connected to the uppermost first gate electrode 120, and the position of the uppermost second pad portion 174 connected to the uppermost second gate electrode 170 in the first horizontal direction X may be the same as the position of the uppermost first pad portion 124 connected to the uppermost first gate electrode 120 in the first horizontal direction X.

The second cover insulating layer 190 may be disposed to cover the second pad portions 174. The second bit lines BL2 may be connected to a first end portion of the second channel structure 180 (e.g., the first end portion opposite to a second end of the second channel structure 180 connected to the second common source plate 160), and may extend in the second horizontal direction Y.

In some implementations, the first common source plate 110 and the second common source plate 160 include doped polysilicon. The first bit lines BL1 and the second bit lines BL2 may include at least one of titanium, titanium nitride, tungsten, tungsten nitride, ruthenium, molybdenum, copper, nickel, and aluminum.

As shown in FIG. 5, a portion of the second cell array stack CS2 formed in the extension region EXT may have the same shape as that of a portion of the first cell array stack CS1 formed in the extension region EXT. For example, each of the first gate electrodes 120 may include a first extension portion 120E, and the first extension portion 120E may indicate portions of the first gate electrodes 120 located below the first pad portions 124. A first insulating pattern 126 may be located in an opening 126H passing through the first extension portions 120E. In addition, each of the second gate electrodes 170 may include a second extension portion 170E, and the second extension portion 170E may indicate portions of the second gate electrodes 170 located below the second pad portions 174. A second insulating pattern 176 may be located in an opening 176H passing through the second extension portions 170E.

A vertical contact CT may extend in the vertical direction Z through the first cell array stack CS1 and the second cell array stack CS2. The vertical contact CT may extend in the vertical direction Z through any one of the first pad portions 124, the first extension portions 120E of the first gate electrodes 120 disposed below the any one of the first pad portions 124, any one of the second pad portions 174, and the second extension portions 170E of the second gate electrodes 170 disposed below the any one of the second pad portions 174.

The vertical contact CT may be located to pass through the first insulating pattern 126 located between the first extension portions 120E and the vertical contact CT, and thus, the first extension portions 120E may not be electrically connected to the vertical contact CT. In addition, the vertical contact CT may be located to pass through the second insulating pattern 176 located between the second extension portions 170E and the vertical contact CT, and thus, the second extension portions 170E may not be electrically connected to the vertical contact CT.

The vertical contact CT may extend in the vertical direction Z to pass through the first cell array stack CS1 and the second cell array stack CS2 over the total height of the first cell array stack CS1 and the second cell array stack CS2, and one end portion of the vertical contact CT may be connected to the contact pad 80 located in the peripheral circuit stack PS. The peripheral circuit transistor 60TR (e.g., a word line control circuit XDEC) included in the peripheral circuit stack PS may be electrically connected to the vertical contact CT through the contact pad 80.

One vertical contact CT may be configured to apply a word line driving voltage (or a pass voltage) from the peripheral circuit transistor 60TR (e.g., the word line control circuit XDEC) included in the peripheral circuit stack PS to the first gate electrode 120 electrically connected to the first pad portion 124 by the first pad portion 124, and in addition, one vertical contact CT may be configured to apply a word line driving voltage (or a pass voltage) from the peripheral circuit transistor 60TR (e.g., the word line control circuit XDEC) included in the peripheral circuit stack PS to the second gate electrode 170 electrically connected to the second pad portion 174 by the second pad portion 174. Accordingly, the same driving voltage may be applied to the first pad portion 124 and the second pad portion 174 electrically connected to one vertical contact CT.

In some implementations, as shown in FIG. 7, any one of the first gate electrodes 120 may be electrically connected to any one of the second gate electrodes 170 corresponding thereto by the vertical contact CT. For example, as shown in FIG. 7, the first gate electrodes 120 may include first to fourth lower word lines WL11, WL12, WL13, and WL14 that are sequentially arranged and the second gate electrodes 170 may include first to fourth upper word lines WL21, WL22, WL23, and WL24 that are sequentially arranged.

The first lower word line WL11 may be electrically connected to the first upper word line WL21 by a first vertical contact CT1, the second lower word line WL12 may be electrically connected to the second upper word line WL22 by a second vertical contact CT2, the third lower word line WL13 may be electrically connected to the third upper word line WL23 by a third vertical contact CT3, and the fourth lower word lines WL14 may be electrically connected to the fourth upper word line WL24 by a fourth vertical contact CT4. Although FIG. 7 shows that the first to fourth vertical contacts CT1, CT2, CT3, and CT4 are arranged to be offset in the first horizontal direction X and the second horizontal direction Y, alternatively, as shown in FIG. 4, the first to fourth vertical contacts CT1, CT2, CT3, and CT4 may be aligned with each other in the second horizontal direction Y and arranged on a straight line in the first horizontal direction X.

A first connection portion CTE1 between the vertical contact CT and the first pad portion 124 of the first gate electrode 120 may refer to an annular conductive region planarly surrounding or laterally surrounding the vertical contact CT. The first connection portion CTE1 may be located in a position vertically overlapping the first insulating patterns 126. A second connection portion CTE2 between the vertical contact CT and the second pad portion 174 of the second gate electrode 170 may refer to an annular conductive region planarly surrounding or laterally surrounding the vertical contact CT. The second connection portion CTE2 may be located in a position vertically overlapping the second insulating patterns 176.

In some implementations, the first word lines WL1 and the second word lines WL2 may be connected to a common word line driving circuit P_Wn (or a pass transistor) by the first pad portion 124 and the second pad portion 174 located in overlapping positions. For example, when the first word lines WL1 have n layers in the vertical direction Z and the second word lines WL2 have n layers in the vertical direction Z, the number of word line driving circuits P_Wn may be n.

In some implementations, the first ground select line GSL1 may be electrically connected to the second ground select line GSL2 vertically overlapping the first ground select line GSL1 by the vertical contact CT, and the first string select line SSL1 may be electrically connected to the second string select line SSL2 vertically overlapping the first string select line SSL1 by the vertical contact CT. The vertical contact CT passing through both the first pad portion 124 connected to the first ground select line GSL1 and the second pad portion 174 connected to the second ground select line GSL2 may be commonly connected to a ground select line driving circuit P_G. In addition, the vertical contact CT passing through both the first pad portion 124 connected to the first string select line SSL1 and the second pad portion 174 connected to the second string select line SSL2 may be commonly connected to a string select line driving circuit P_S.

The vertical contact CT may pass through the first common source plate 110 and the second common source plate 160. For example, as shown in FIG. 5, a first insulation filling layer 112 may be located between the first common source plate 110 and the vertical contact CT, and a second insulation filling layer 162 may be located between the second common source plate 160 and the vertical contact CT, so that the vertical contact CT may not be electrically connected to the first common source plate 110 and the second common source plate 160.

The first bit lines BL1 may be configured to receive a bit line driving voltage from a peripheral circuit transistor 60TR (e.g., a first page buffer circuit PGBP1) included in the peripheral circuit stack PS, and the second bit lines BL2 may be configured to receive a bit line driving voltage from a peripheral circuit transistor 60TR (e.g., a second page buffer circuit PGBP2) included in the peripheral circuit stack PS.

As shown in FIG. 6, the second bit lines BL2 may be arranged to be relatively close to the peripheral circuit stack PS, and the first bit lines BL1 may be arranged to be relatively far from the peripheral circuit stack PS. The first bit lines BL1 may be electrically connected to the peripheral circuit transistor 60TR (e.g., the first page buffer circuit PGBP1) included in the peripheral circuit stack PS through the bit line connection contact BCT. The bit line connection contact BCT may be located in a peripheral region of the second cell array stack CS2 and extend through the second cell array stack CS2 over the total height of the second cell array stack CS2 in the vertical direction Z. The second bit lines BL2 may be electrically connected to the peripheral circuit transistor 60TR (e.g., the second page buffer circuit PGBP2) included in the peripheral circuit stack PS through the contact pad 80.

In general, as the number of layers of the memory device increases, the area of the pad portion formation region connected to each word line and/or the area of the word line driving circuit (or the pass transistor) region connected to the pad portion increases. Accordingly, there are restrictions on increasing the area of the memory cell array region included in the entire memory device.

According to the implementations described above, the first cell array stack CS1 and the second cell array stack CS2 may include the first pad portion 124 and the second pad portion 174 located in positions vertically overlapping each other and may be commonly connected to the word line control circuit XDEC by the vertical contact CT passing through the first pad portion 124 and the second pad portion 174. Accordingly, the area of the pad portion formation region and/or the area of the word line driving circuit (or the pass transistor) region connected to the pad portion may be reduced to approximately 50%. Accordingly, the memory device 100 may be advantageous in improving the degree of integration.

In addition, according to some implementations described above, because the first NAND string MS1 and the second NAND string MS2, which are apart from each other in the vertical direction Z, instead of one NAND string, are included, a cell current supplied into the channel structures 130 and 180 may increase in each NAND string, and the memory device 100 may have improved electrical performance.

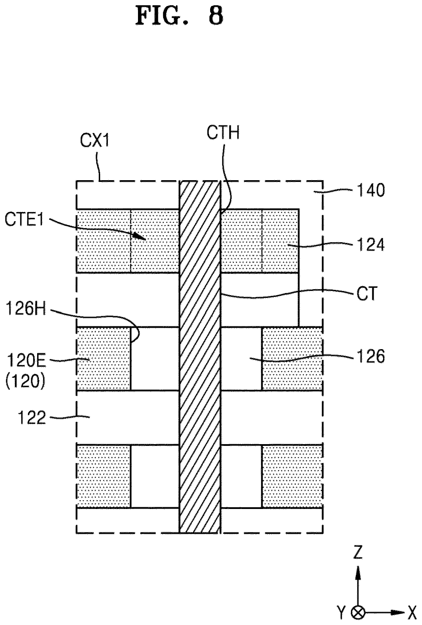

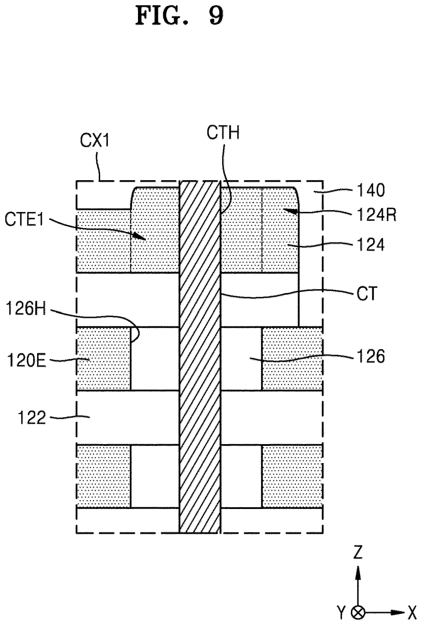

FIGS. 8 and 9 illustrate structures of the first pad portion 124 that may be employed in a memory device according to some implementations. FIGS. 8 and 9 correspond to enlarged views of portion CX1 of FIG. 5.

Referring to FIG. 8, the first gate electrodes 120 may be alternately arranged with the first insulating layers 122, and the vertical contact hole CTH may extend in the vertical direction Z through the first gate electrodes 120 and the first insulating layers 122. The first pad portions 124 may extend from the first gate electrodes 120 and have a step shape, and the first cover insulating layer 140 covering the first pad portions 124 may be provided.

A portion of the vertical contact CT may be surrounded by the first pad portion 124, and a region of the first pad portion 124 surrounding a portion of the vertical contact CT may be referred to as a first connection portion CTE1. The first connection portion CTE1 may have a top surface and a bottom surface disposed on the same surface as the first pad portion 124 and may have an annular shape surrounding the vertical contact CT planarly.

Portions of the first gate electrodes 120 disposed below the first pad portion 124 may be referred to as the first extension portion 120E. The first extension portion 120E may indicate portions of the first gate electrodes 120 disposed below the first pad portions 124. The first insulating pattern 126 may be located in the opening 126H passing through the first extension portions 120E. The first insulating pattern 126 may have an annular shape surrounding the vertical contact CT and may have top and bottom surfaces located on the same plane as the top and bottom surfaces of the first extension portions 120E.

FIG. 8 shows only a connection portion between the first pad portion 124 included in the first cell array stack CS1 and the vertical contact CT, but a connection portion between the second pad portion included in the second cell array stack CS2 and the vertical contact CT may also have a shape similar to that illustrated in FIG. 8.

Referring to FIG. 9, the first pad portion 124 may have a greater thickness in the vertical direction Z than the first gate electrode 120 and the first extension portion 120E. A raised portion 124R may be disposed above the first pad portion 124, and an upper surface of the raised portion 124R may be covered by the first cover insulating layer 140.

Although FIG. 9 shows that the first insulating pattern 126 is formed with a uniform width over the total height thereof, in other implementations, a width of the upper side of the first insulating pattern 126 in the horizontal direction may be greater than a width of the lower side of the first insulating pattern 126. In other implementations, voids or seams may be further formed inside the first insulating pattern 126.

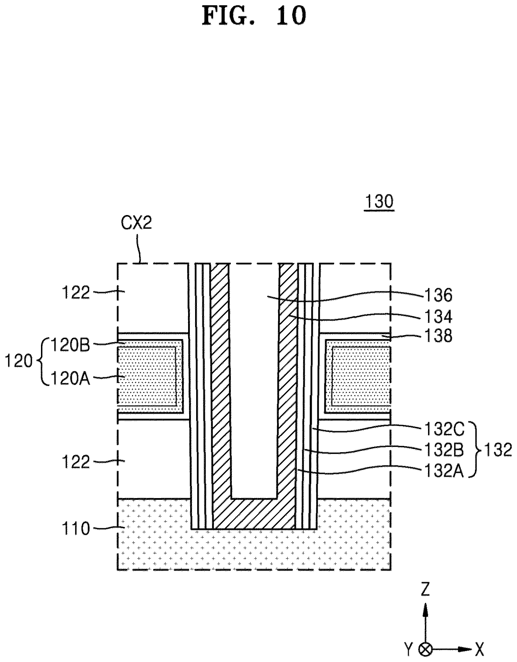

FIGS. 10 to 13 illustrate structures of the first channel structure 130 that may be employed in a memory device according to some implementations. FIGS. 10 to 13 correspond to enlarged views of portion CX2 of FIG. 5.

Referring to FIG. 10, the first channel structure 130 may extend from an upper surface of the first common source plate 110 through the first gate electrodes 120 and the first insulating layers 122 in the vertical direction (the Z direction). Each of the first channel structures 130 may be located within a channel hole 130H.

Each of the first channel structures 130 includes a gate insulating layer 132, a channel layer 134, a buried insulating layer 136, and a conductive plug 138 (refer to FIG. 5). The gate insulating layer 132 and the channel layer 134 may be sequentially arranged on the sidewall of the channel hole 130H. For example, the gate insulating layer 132 may be conformally disposed on the sidewall of the channel hole 130H, and the channel layer 134 may be conformally located on the sidewall and bottom portion of the channel hole 130H. The buried insulating layer 136 filling a remaining space of the channel hole 130H may be disposed on the channel layer 134. The conductive plug 138 that contacts the channel layer 134 and blocks an entrance of the channel hole 130H may be located above the channel hole 130H. In other implementations, the buried insulating layer 136 may be omitted, and the channel layer 134 may be formed in a pillar shape filling the remaining portion of the channel hole 130H.

In some implementations, the channel layer 134 may be disposed to contact an upper surface of the first common source plate 110 at the bottom of the channel hole 130H. In some examples, as shown in FIG. 10, a bottom surface of the channel layer 134 may be disposed at a vertical level lower than an upper surface of the first common source plate 110 but is not limited thereto.

As shown in FIG. 10, the gate insulating layer 132 has a structure including a tunneling dielectric layer 132A, a charge storage layer 132B, and a blocking dielectric layer 132C sequentially on an outer wall of the channel layer 134. Relative thicknesses of the tunneling dielectric layer 132A, the charge storage layer 132B, and the blocking dielectric layer 132C constituting the gate insulating layer 132 are not limited to those illustrated in FIG. 8 and may be variously modified.

The tunneling dielectric layer 132A may include silicon oxide, hafnium oxide, aluminum oxide, zirconium oxide, tantalum oxide, or the like. The charge storage layer 132B may be a region in which electrons passing through the tunneling dielectric layer 132A from the channel layer 134 may be stored and may include silicon nitride, boron nitride, silicon boron nitride, or polysilicon doped with impurities. The blocking dielectric layer 132C may include silicon oxide, silicon nitride, or a metal oxide having a dielectric constant higher than that of silicon oxide. The metal oxide may include hafnium oxide, aluminum oxide, zirconium oxide, tantalum oxide, or combinations thereof.

In some implementations, a blocking insulating layer 139 is located between the first channel structure 130 and the first gate electrodes 120. For example, the blocking insulating layer 139 may be located between the first channel structure 130 and the first gate electrode 120 and on top and bottom surfaces of the first gate electrode 120. In some implementations, the blocking insulating layer 139 may include silicon oxide, silicon nitride, or a metal oxide having a dielectric constant higher than that of silicon oxide. The metal oxide may include hafnium oxide, aluminum oxide, zirconium oxide, tantalum oxide, or combinations thereof.

In some implementations, the first gate electrodes 120 may include a buried conductive layer 120A and a conductive barrier layer 120B surrounding top, bottom, and side surfaces of the buried conductive layer 120A. For example, the buried conductive layer 120A may include a metal, such as tungsten, nickel, cobalt, tantalum, or molybdenum, a metal silicide, such as tungsten silicide, nickel silicide, cobalt silicide, and tantalum silicide, doped polysilicon, or combinations thereof. In some embodiments, the conductive barrier layer 120B may include titanium nitride (TiN), tantalum nitride (TaN), tungsten nitride (WN), or combinations thereof.

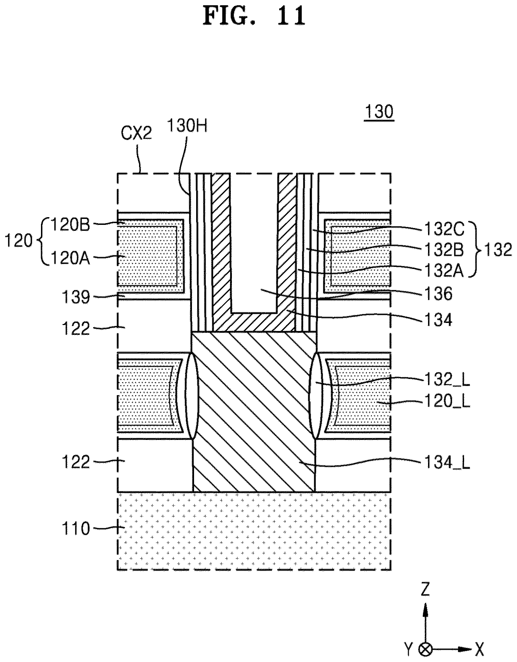

Referring to FIG. 11, the first channel structure 130 includes a gate insulating layer 132, a channel layer 134, a buried insulating layer 136, and a conductive plug 138 (refer to FIG. 5) and may further include a contact semiconductor layer 134_L and a bottom insulating layer 132_L arranged at the bottom of the channel hole 130H. The channel layer 134 may not directly contact the first common source plate 110, and the channel layer 134 may be electrically connected to the first common source plate 110 through the contact semiconductor layer 134L. In some implementations, the contact semiconductor layer 134L may include a silicon layer formed by a selective epitaxy growth (SEG) process using the first common source plate 110 disposed at the bottom of the channel hole 130H as a seed layer.

A bottom insulating layer 132_L may be located between the lowermost first gate electrode 120_L and the contact semiconductor layer 134_L. In some implementations, the bottom insulating layer 132_L may include silicon oxide and may be formed by preforming, for example, an oxidation process on a portion of a sidewall of the contact semiconductor layer 134_L.

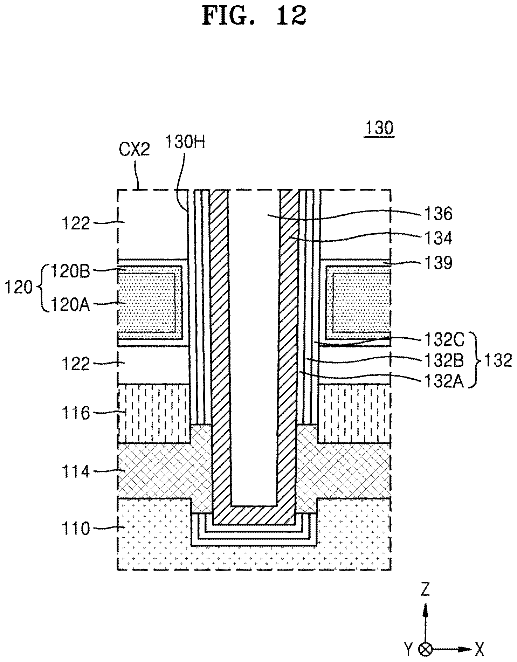

Referring to FIG. 12, a horizontal semiconductor layer 114 and a support layer 116 may be sequentially stacked on the first common source plate 110.

In some implementations, the horizontal semiconductor layer 114 may include impurity-doped polysilicon or undoped polysilicon. The horizontal semiconductor layer 114 may function as a portion of a common source region connecting the first common source plate 110 to the channel layer 134. For example, the support layer 116 may include doped or undoped polysilicon. The support layer 116 may serve as a support layer to prevent a mold stack from collapsing or falling in a process of removing a sacrificial material layer (not shown) for forming the horizontal semiconductor layer 114.

As shown in FIG. 12, the gate insulating layer 132 may be disposed on an inner wall and a bottom portion of the channel hole 130H. A bottom surface of the channel layer 134 may be disposed on the gate insulating layer 132 not to directly contact the first common source plate 110, and a sidewall of the bottom portion of the channel layer 134 may be surrounded by the horizontal semiconductor layer 114.

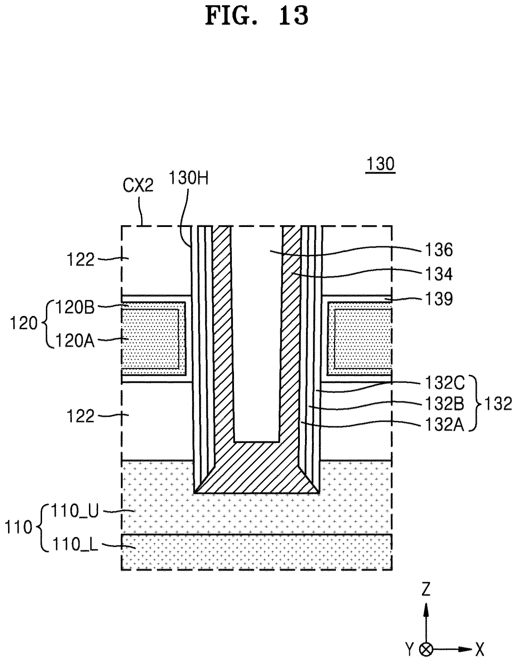

Referring to FIG. 13, the first common source plate 110 may be formed as a stacked structure of an upper semiconductor layer 110_U and a lower conductive layer 110_L, and the bottom surface of the channel layer 134 may not be covered by the gate insulating layer 132 and may contact an upper surface of the upper semiconductor layer 110_U.

In some implementations, the upper semiconductor layer 110_U may include polysilicon doped with impurities, and the lower conductive layer 110_L may include a metal, such as tungsten or titanium, or a metal silicide, such as tungsten silicide, titanium silicide, cobalt silicide, or nickel silicide. A bottom surface of the channel layer 134 may not be covered by the gate insulating layer 132 and may contact the upper surface of the upper semiconductor layer 110_U.

Various examples of the first channel structure 130 have been described with reference to FIGS. 10 to 13, and the second channel structure 180 may have a structure that is the same as or similar to that of any one of the first channel structures 130 described with above with reference to FIGS. 10 to 13. In addition, the first channel structure 130 and the second channel structure 180 are not limited to the structures shown in FIGS. 10 to 13. In other implementations, a configuration in which the first and second channel structures 130 and 180 are connected to the first and second common source plates 110 and 160 may have various modified shapes.

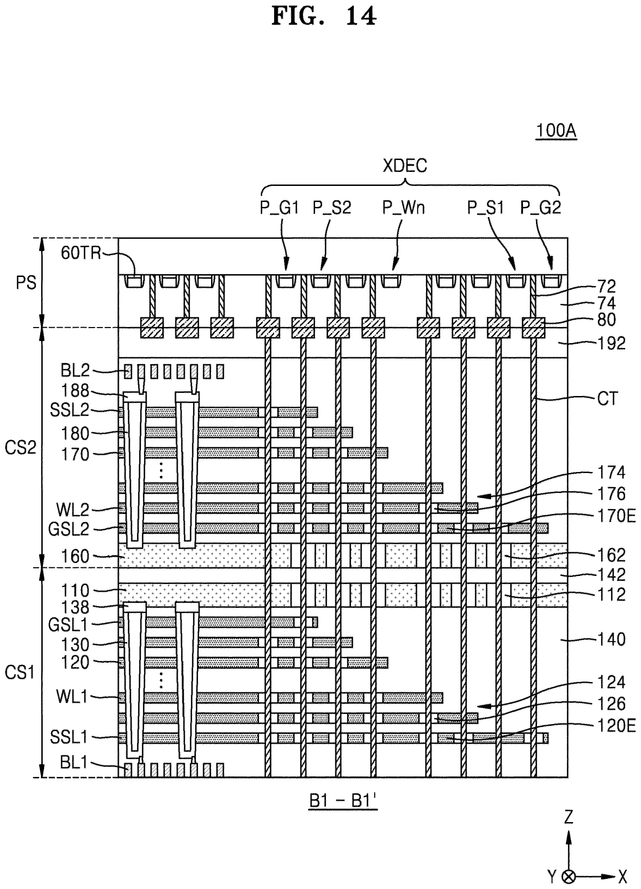

FIG. 14 is a cross-sectional view illustrating a memory device 100A according to some implementations.

Referring to FIG. 14, the first cell array stack CS1 may include a plurality of first bit lines BL1 arranged below the first channel structure 130 and the first gate electrodes 120 and the first common source plate 110 disposed on the first channel structure 130 and the first gate electrodes 120. That is, the first common source plate 110 and the second common source plate 160 may be located between the first channel structure 130 and the second channel structure 180, and an intermediate insulating layer 142 may be located between the first common source plate 110 and the second common source plate 160 so that the first common source plate 110 may not be electrically connected to the second common source plate 160.

In some embodiments, a metal interconnection layer may be further provided between the first common source plate 110 and the intermediate insulating layer 142 and/or between the second common source plate 110 and the intermediate insulating layer 142 so that resistance of the first common source plate 110 and the second common source plate 160 is reduced. In some other implementations, the intermediate insulating layer 142 may be omitted, and the first common source plate 110 may be integrally connected to the second common source plate 160. In some other implementations, the intermediate insulating layer 142 may be omitted, and a metal interconnection layer may be located between the first common source plate 110 and the second common source plate 160 so that the first common source plate 110 may be electrically connected to the second common source plate 160.

Among the first gate electrodes 120, the lowermost first gate electrode 120, for example, the first gate electrode 120 disposed farthest from the peripheral circuit stack PS, may be the first string select line SSL1, and among the first gate electrodes 120, the uppermost first gate electrode 120, for example, the first gate electrode 120 disposed closest to the peripheral circuit stack PS, may be the first ground select line GSL1. Also, among the first gate electrodes 120, the first gate electrodes 120 other than the lowermost and uppermost first gate electrodes 120 may be the first word line WL1.

Among the second gate electrodes 170, the lowermost second gate electrode 170, for example, the second gate electrode 170 disposed farthest from the peripheral circuit stack PS, may be the second ground select line GSL2, and among the second gate electrodes 170, the uppermost second gate electrode 170, for example, the second gate electrode 170 disposed closest to the peripheral circuit stack PS, may be the second string select line SSL2. Also, among the second gate electrodes 170, the second gate electrodes 170 other than the lowermost and uppermost second gate electrodes 170 may be the second word line WL2.

In some implementations, the first word lines WL1 and the second word lines WL2 may be connected to the common word line driving circuit P_Wn (or the pass transistor) by the first pad portion 124 and the second pad portion 174 arranged in overlapping positions. For example, when the first word lines WL1 have n layers in the vertical direction Z and the second word lines WL2 have n layers in the vertical direction Z, the number of word line driving circuits P_Wn may be n.

The first pad portion 124 connected to the first ground select line GSL1 may be located in a position vertically overlapping the second pad portion 174 connected to the second string select line SSL2.

The vertical contact CT passing through the first pad portion 124 connected to the first ground select line GSL1 may pass through the second pad portion 174 connected to the second string select line SSL2 and may not be electrically connected to the second pad portion 174. The vertical contact CT passing through the first pad portion 124 connected to the first ground select line GSL1 may be connected alone to the first ground select line driving circuit P_G1. In addition, the vertical contact CT passing through the second pad portion 174 connected to the second string select line SSL2 may pass through the first pad portion 124 connected to the first ground select line GSL1 but may not be electrically connected to the first pad portion 124. The vertical contact CT passing through the second pad portion 174 connected to the second string select line SSL2 may be connected alone to the second string select line driving circuit P_S2.

The vertical contact CT passing through the first pad portion 124 connected to the first string select line SSL1 may pass through the second pad portion 174 connected to the second ground select line GSL2 but may not be electrically connected to the second pad portion 174. The vertical contact CT passing through the first pad portion 124 connected to the first string select line SSL1 may be connected alone to the first string select line driving circuit P_S1. In addition, the vertical contact CT passing through the second pad portion 174 connected to the second ground select line GSL2 may pass through the first pad portion 124 connected to the first string select line SSL1 but may not be electrically connected to the first pad portion 124. The vertical contact CT passing through the second pad portion 174 connected to the second ground select line GSL2 may be connected alone to the second ground select line driving circuit P_G2.

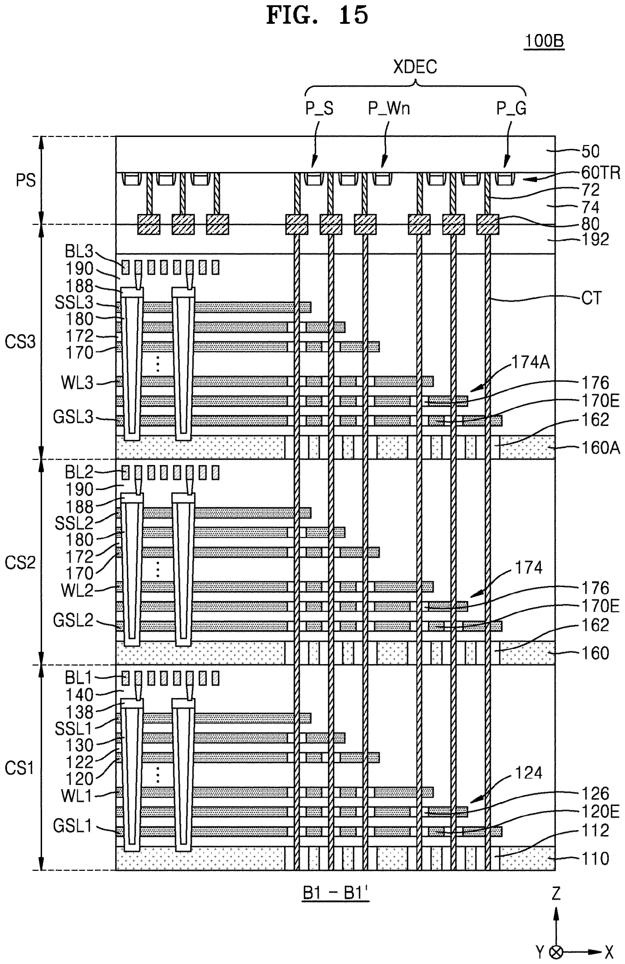

FIG. 15 is a cross-sectional view illustrating a memory device 100B according to some implementations.

Referring to FIG. 15, a third cell array stack CS3 is further located between the peripheral circuit stack PS and the second cell array stack CS2, and the vertical contacts CT may pass through the first to third array stacks CS1, CS2, and CS3 and extend in the vertical direction Z over the total height of the first to third cell array stacks CS1, CS2, and CS3.

The third cell array stack CS3 may have the same structure as that of the cell array stack CS2, and may include, for example, a third ground select line GSL3, a plurality of third word lines WL3, and a third string select line SSL3 and may further include a plurality of third bit lines BL3.

The first word lines WL1, the second word lines WL2, and the third word lines WL3 may be connected to the common word line driving circuit P_Wn (or the pass transistor) by the first pad portion 124, the second pad portion 174, and a third pad portion 174A arranged in overlapping positions. For example, when the first word lines WL1 have n layers in the vertical direction Z, the second word lines WL2 have n layers in the vertical direction Z, and the third word lines WL3 have n layers in the vertical direction Z, the number of word line driving circuits P_Wn may be n.

The vertical contact CT passing through all of the first pad portion 124 connected to the first ground select line GSL1, the second pad portion 174 connected to the second ground select line GSL2, and the third pad portion 174A connected to the third ground select line GSL3 may be commonly connected to the ground select line driving circuit P_G. Also, the vertical contact CT passing through all of the first pad portion 124 connected to the first string select line SSL1, the second pad portion 174 connected to the second string select line SSL2, and the third pad portion 174A connected to the third string select line SSL3 may be commonly connected to the string select line driving circuit P_S.

According to some implementations, three cell array stacks may be stacked in the vertical direction Z, three strings may be configured in the vertical direction Z, and the three strings may have the same electrical characteristics. For example, the first memory cell, the second memory cell, and the third memory cell respectively constituted by the first word line WL1, the second word line WL2, and the third word line WL3 connected to one word line driving circuit P_Wn may have the same size (e.g., the width of the channel hole width, the thickness of the channel layer, etc.), and thus, the first memory cell, the second memory cell, and the third memory cell may have the same electrical characteristics, such as the same or similar threshold voltage.

FIG. 15 shows that three cell array stacks are stacked in the vertical direction Z and three strings are configured in the vertical direction Z. In other implementations, m cell array stacks ( m is greater than three) may be stacked in the vertical direction Z to configure m strings in the vertical direction Z, and the word line control circuit XDEC may be commonly connected to m pad portions arranged in vertically overlapping positions.

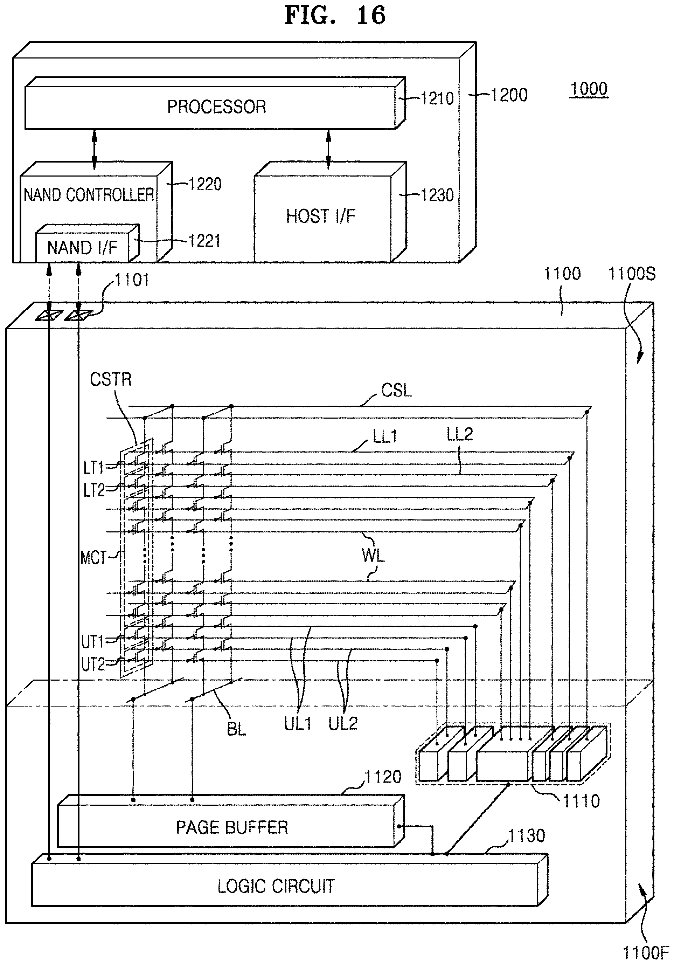

FIG. 16 is a diagram schematically illustrating a data storage system 1000 including a memory device according to some implementations.

Referring to FIG. 16, the data storage system 1000 may include at least one memory device 1100 and a memory controller 1200 electrically connected to the memory device 1100. The data storage system 1000 may be, for example, a solid state drive (SSD) device including at least one memory device 1100, a universal serial bus (USB), a computing system, a medical device, or a communication device.

The memory device 1100 may be a nonvolatile semiconductor device, and for example, the memory device 1100 may include a NAND flash semiconductor device including one of the memory devices 10, 100, 100A, and 100B described above with reference to FIGS. 1 to 15. The memory device 1100 may include a first structure 1100F and a second structure 1100S on the first structure 1100F. The first structure 1100F may be a peripheral circuit structure including a row decoder 1110, a page buffer 1120, and a logic circuit 1130.

The second structure 1100S may be a memory cell structure including a bit line BL, a common source line CSL, a plurality of word lines WL, first and second string select lines UL 1 and UL2, first and second ground select lines LL1 and LL2, and a plurality of memory cell strings CSTR between the bit line BL and the common source line CSL.

In the second structure 1100S, the memory cell strings CSTR may each include ground select transistors LT1 and LT2 adj acent to the common source line CSL, string select transistors UT1 and UT2 adjacent to the bit line BL, and a plurality of memory cell transistors MCT located between the ground select transistors LT1 and LT2 and the string select transistors UT1 and UT2. The number of ground select transistors LT1 and LT2 and the number of string select transistors UT1 and UT2 may be variously modified according to some implementations.

In some implementations, the ground select lines LL1 and LL2 may be connected to gate electrodes of the ground select transistors LT1 and LT2, respectively. The word line WL may be connected to a gate electrode of the memory cell transistor MCT. The string select lines UL1 and UL2 may be connected to gate electrodes of the string select transistors UT1 and UT2, respectively.

The common source line CSL, the ground select lines LL1 and LL2, the word lines WL, and the string select lines UL1 and UL2 may be connected to the row decoder 1110. The bit lines BL may be electrically connected to the page buffer 1120.

The memory device 1100 may communicate with the memory controller 1200 through an I/O pad 1101 electrically connected to a logic circuit 1130. The I/O pad 1101 may be electrically connected to the logic circuit 1130.

The memory controller 1200 may include a processor 1210, a NAND controller 1220, and a host interface 1230. In some embodiments, the data storage system 1000 may include a plurality of memory devices 1100, and in this case, the memory controller 1200 may control the memory devices 1100.

The processor 1210 may control overall operations of the data storage system 1000 including the memory controller 1200. The processor 1210 may operate according to certain firmware and may access the memory device 1100 by controlling the NAND controller 1220. The NAND controller 1220 may include a NAND interface 1221 that processes communication with the memory device 1100. Through the NAND interface 1221, a control command for controlling the memory device 1100, data to be written to the memory cell transistors MCT of the memory device 1100, and data to be read from the memory cell transistors MCT of the memory device 1100 may be transmitted. The host I/F 1230 may provide a communication function between the data storage system 1000 and an external host. When a control command is received from an external host through the host I/F 1230, the processor 1210 may control the memory device 1100 in response to the control command.

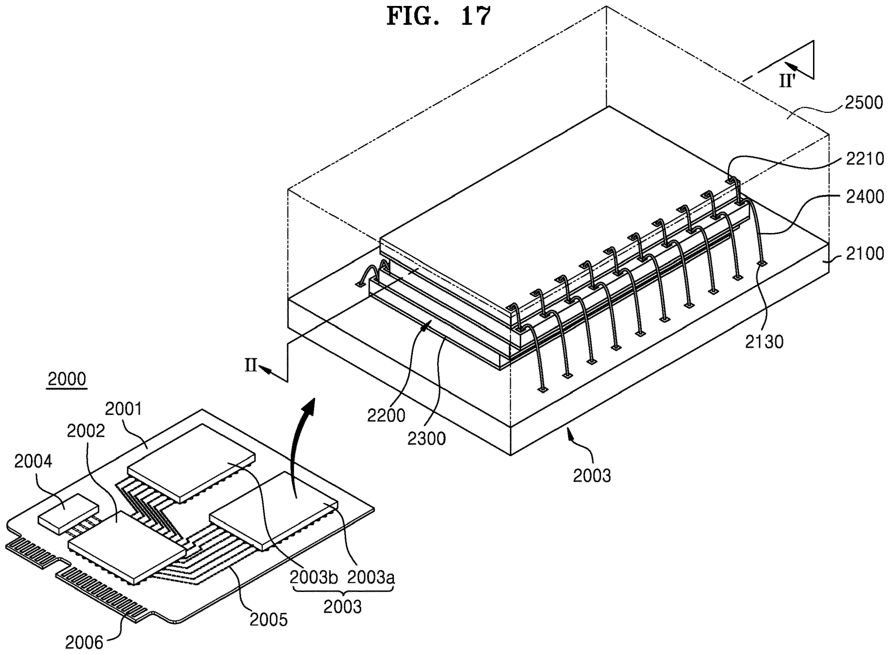

FIG. 17 is a schematic perspective view of a data storage system 2000 including a semiconductor device according to some implementations.

Referring to FIG. 17, the data storage system 2000 according to an embodiment may include a main substrate 2001, a memory controller 2002 mounted on the main substrate 2001, one or more semiconductor packages 2003, and a dynamic random-access memory (DRAM) 2004. The semiconductor package 2003 and the DRAM 2004 may be connected to the memory controller 2002 by a plurality of interconnection patterns 2005 formed on the main substrate 2001.

The main substrate 2001 may include a connector 2006 including a plurality of pins coupled to an external host. The number and arrangement of the pins of the connector 2006 may vary depending on a communication interface between the data storage system 2000 and the external host. In some implementations, the data storage system 2000 may communicate with an external host according to any one of interfaces such as a universal serial bus (USB), a peripheral component interconnect express (PCI-Express), a serial advanced technology attachment (SATA), M-Phy for a universal flash storage (UFS), etc. In some implementations, the data storage system 2000 may operate by power supplied from an external host through the connector 2006. The data storage system 2000 may further include a power management integrated circuit (PMIC) for distributing power supplied from the external host to the memory controller 2002 and the semiconductor package 2003.

The memory controller 2002 may write data to or read data from the semiconductor package 2003, and may improve an operating speed of the data storage system 2000.

The DRAM 2004 may be a buffer memory for mitigating a speed difference between the semiconductor package 2003 as a data storage space and the external host. The DRAM 2004 included in the data storage system 2000 may also operate as a kind of cache memory, and may provide a space for temporarily storing data in a control operation for the semiconductor package 2003. When the DRAM 2004 is included in the data storage system 2000, the memory controller 2002 may further include a DRAM controller for controlling the DRAM 2004 in addition to the NAND controller for controlling the semiconductor package 2003.

The semiconductor package 2003 may include first and second semiconductor packages 2003a and 2003b apart from each other. Each of the first and second semiconductor packages 2003a and 2003b may be a semiconductor package including a plurality of semiconductor chips 2200. Each of the first and second semiconductor packages 2003a and 2003b may include a package substrate 2100, a plurality of semiconductor chips 2200 on the package substrate 2100, an adhesive layer 2300 disposed on a lower surface of each of the semiconductor chips 2200, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be a PCB including a plurality of package upper pads 2130. Each of the semiconductor chips 2200 may include an I/O pad 2210. The I/O pad 2210 may correspond to the I/O pad 1101 of FIG. 16. Each of the semiconductor chips 2200 may include at least one of the memory devices 10, 100, 100A, 100B described above with reference to FIGS. 1 to 15.

In some implementations, the connection structure 2400 may be a bonding wire electrically connecting the I/O pad 2210 to the package upper pad 2130. Accordingly, in the first and second semiconductor packages 2003a and 2003b, the semiconductor chips 2200 may be electrically connected to each other by a bonding wire method, and may be electrically connected to the package upper pad 2130 of the package substrate 2100. In some implementations, in the first and second semiconductor packages 2003a and 2003b, the semiconductor chips 2200 may be electrically connected to each other by a connection structure including a through-silicon via (TSV), instead of the bonding wire type connection structures 2400.

In some implementations, the memory controller 2002 and the semiconductor chips 2200 may be included in a single package. In an embodiment, the memory controller 2002 and the semiconductor chips 2200 may be mounted on a separate interposer substrate, different from the main substrate 2001, and the memory controller 2002 may be connected to the semiconductor chips 2200 by an interconnection formed on the interposer substrate.

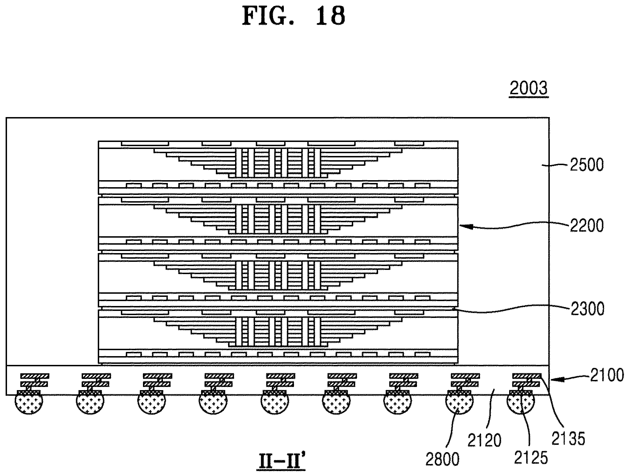

FIG. 18 is a schematic cross-sectional view of semiconductor packages 2003 according to some implementations. FIG. 18 is a cross-sectional view taken along line II-II' of FIG. 17.

Referring to FIG. 18, in the semiconductor package 2003, the package substrate 2100 may be a printed circuit substrate. The package substrate 2100 may include a package substrate body portion 2120, a plurality of package upper pads 2130 (refer to FIG. 17) disposed on an upper surface of the package substrate body portion 2120, a plurality of lower pads 2125 disposed on a lower surface of the package substrate body portion 2120 or exposed through the lower surface of the package substrate body portion 2120, and a plurality of internal interconnections 2135 electrically connecting the package upper pads 2130 (refer to FIG. 17) to the lower pads 2125 in the package substrate body portion 2120. As shown in FIG. 18, the package upper pads 2130 may be electrically connected to the connection structures 2400. As shown in FIG. 18, the lower pads 2125 may be connected to the interconnection patterns 2005 on the main substrate 2001 of the data storage system 2000 shown in FIG. 31 through a plurality of conductive bumps 2800. Each of the semiconductor chips 2200 may include at least one of the memory devices 10, 100, 100A, and 100B described above with reference to FIGS. 1 to 15.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

While the disclosure has been particularly shown and described with reference to implementations thereof, it will be understood that various changes in form and details may be made therein without departing from the spirit and scope of the following claims.

## Claims

1. A memory device comprising:
a first cell array stack including a plurality of first gate electrodes arranged to be apart from each other in a first direction, a first channel structure passing through the plurality of first gate electrodes, and a plurality of first pad portions respectively connected to the plurality of first gate electrodes, wherein the plurality of first pad portions are arranged to have a step shape;
a second cell array stack disposed on the first cell array stack, wherein the second cell array stack includes a plurality of second gate electrodes arranged to be apart from each other in the first direction, a second channel structure passing through the plurality of second gate electrodes, and a plurality of second pad portions respectively connected to the plurality of second gate electrodes, wherein the plurality of second pad portions are arranged to have a step shape, and wherein the plurality of second pad portions overlap the plurality of first pad portions in the first direction; and
a vertical contact passing through any one of the plurality of first pad portions, first extension portions of the plurality of first gate electrodes arranged below the any one of the plurality of first pad portions, any one of the plurality of second pad portions, and second extension portions of the plurality of second gate electrodes arranged below the any one of the plurality of second pad portions, to extend in the first direction.

2. The memory device of claim 1, wherein the vertical contact is electrically connected to the any one of the plurality of first pad portions, and the vertical contact is electrically connected to the any one of the plurality of second pad portions.

3. The memory device of claim 1 or 2, further comprising:
a plurality of first insulating patterns arranged between the vertical contact and the plurality of first extension portions to electrically separate the vertical contact from the plurality of first extension portions; and
a plurality of second insulating patterns arranged between the vertical contact and the plurality of second extension portions to electrically separate the vertical contact from the plurality of second extension portions.

4. The memory device of any one of claims 1 to 3, wherein
the first cell array stack further includes:
a first bit line connected to a first end portion of the first channel structure; and
a first common source plate connected to a second end portion of the first channel structure, and
the second cell array stack further includes:
a second bit line connected to a first end portion of the second channel structure; and
a second common source plate connected to a second end portion of the second channel structure.

5. The memory device of claim 4, wherein the second bit line is located at a vertical level that is different from a vertical level of the first bit line, and the second common source plate is located at a vertical level that is different from a vertical level of the first common source plate.

6. The memory device of claim 4 or 5, wherein the first bit line is located at a vertical level that is lower than a vertical level of the second common source plate and higher than vertical levels of the plurality of first gate electrodes.

7. The memory device of any one of claims 4 to 6, wherein
the plurality of first gate electrodes include:
a first ground select line that is a lowermost first gate electrode among the plurality of first gate electrodes;
a first string select line that is an uppermost first gate electrode among the plurality of first gate electrodes; and
a first word line that is a remaining first gate electrode among the plurality of first gate electrodes, and
the plurality of second gate electrodes include:
a second ground select line that is a lowermost second gate electrode among the plurality of second gate electrodes;
a second string select line that is an uppermost second gate electrode among the plurality of second gate electrodes; and
a second word line that is a remaining second gate electrode among the plurality of second gate electrodes.

8. The memory device of claim 7, wherein
the vertical contact includes a first vertical contact and a second vertical contact, the first ground select line is electrically connected to the second ground select line by the first vertical contact, and
the first string select line is electrically connected to the second string select line by the second vertical contact.

9. The memory device of any one of claims 4 to 8, further comprising:
a peripheral circuit stack disposed on the second cell array stack, the peripheral circuit stack including
a word line driving circuit electrically connected to the vertical contact,
a first page buffer circuit electrically connected to the first bit line, and
a second page buffer circuit electrically connected to the second bit line.

10. The memory device of claim 9, further comprising a bit line connection contact located in a peripheral region of the second cell array stack, extending in the first direction over a total height of the second cell array stack, and electrically connecting the first bit line to the first page buffer circuit.

11. A memory device comprising:
a first cell array stack including a first common source plate, a plurality of first gate electrodes arranged to be apart from each other in a first direction on the first common source plate, a first channel structure passing through the plurality of first gate electrodes, a plurality of first pad portions respectively connected to the plurality of first gate electrodes, and a first bit line connected to the first channel structure, wherein the plurality of first pad portions are arranged to have a step shape;
a second cell array stack disposed on the first cell array stack, wherein the second cell array stack includes a second common source plate, a plurality of second gate electrodes arranged to be apart from each other in the first direction on the second common source plate, a second channel structure passing through the plurality of second gate electrodes, a plurality of second pad portions respectively connected to the plurality of second gate electrodes, and a second bit line connected to the second channel structure, wherein the plurality of second pad portions are arranged to have a step shape; and
a vertical contact extending in the first direction through any one of the plurality of first pad portions and any one of the plurality of second pad portions, electrically connected to the any one of the plurality of first pad portions, and electrically connected to the any one of the plurality of second pad portions.

12. The memory device of claim 11, wherein
the vertical contact passes through first extension portions of the plurality of first gate electrodes arranged below the any one of the plurality of first pad portions and second extension portions of the plurality of second gate electrodes arranged below the any one of the plurality of second pad portions,
wherein the memory device further comprises:
a plurality of first insulating patterns arranged between the vertical contact and the plurality of first extension portions to electrically separate the vertical contact from the plurality of first extension portions; and
a plurality of second insulating patterns arranged between the vertical contact and the plurality of second extension portions to electrically separate the vertical contact from the plurality of second extension portions.

13. The memory device of claim 11 or 12, wherein
the plurality of first gate electrodes include:
a first ground select line that is a lowermost first gate electrode among the plurality of first gate electrodes;
a first string select line that is an uppermost first gate electrode among the plurality of first gate electrodes; and
a first word line that is a remaining first gate electrode among the plurality of first gate electrodes, and
the plurality of second gate electrodes include:
a second ground select line that is a lowermost second gate electrode among the plurality of second gate electrodes;
a second string select line that is an uppermost second gate electrode among the plurality of second gate electrodes; and
a second word line that is a remaining second gate electrode among the plurality of second gate electrodes.

14. The memory device of claim 13, wherein
the vertical contact includes a first vertical contact and a second vertical contact, the first ground select line is electrically connected to the second ground select line by the first vertical contact, and
the first string select line is electrically connected to the second string select line by the second vertical contact.

15. The memory device of any one of claims 11 to 14, further comprising:
a peripheral circuit stack disposed on the second cell array stack, the peripheral circuit stack including
a word line driving circuit electrically connected to the vertical contact,
a first page buffer circuit electrically connected to the first bit line, and
a second page buffer circuit electrically connected to the second bit line.
